# EUROPEAN PATENT APPLICATION

(11) **EP 4 815 314 A1**
(43) Date of publication of application: **30.09.2026**
(21) Application number: 25166803.4
(22) Date of filing: 27.03.2025
(51) Int. Cl.: H03M 1/18

(54) **REAL-TIME HARDWARE-BASED DIGITAL COMPENSATION OF BASEBAND GAIN CHANGES FOR NFC RECEIVER**

(71) Applicant: NXP B.V., 5656 AG Eindhoven (NL)
(72) Inventor: Lingardo, Luca, 5656 AG eindhoven (NL); Hrauda, Wolfgang, 5656 AG Eindhoven (NL); Muehlmann, Ulrich Andreas, 5656 AG Eindhoven (NL)
(74) Representative: Krott, Michel

(57) **Abstract**

The proposed method improves dynamic range utilization of the ADC unit by adjusting the amplifier gain and a reference gain level used to compensate the amplifier gain adjustment, based on a saturation status of the ADC unit. An update of the reference gain level is performed according to the gain change of the analog amplifier of the received signal and the recent ADCs saturation status. This provides a technical advantage by ensuring that the decoded signal remains steady when the amplifier gain is adjusted, thus maintaining signal integrity. This may help to achieve a more or less steady output in all circumstances. Resulting therefrom, the signal to be decoded is kept constant. This may be useful, when the received signal is strong and the ADC unit is saturated despite adaptation of gain.

## Description

### TECHNICAL FIELD

The present disclosure relates to a method of operating an NFC receiver system, specifically focusing on techniques to handle changes in the gain of analog amplifiers to optimize signal conversion and processing in scenarios where analog-to-digital converters (ADCs) may experience saturation.

### BACKGROUND

In modern receiver systems, converting analog signals to digital signals efficiently is important for maintaining high fidelity in signal processing. This conversion is typically achieved using analog-to-digital converters (ADCs), which are fed signals from analog amplifiers, such as baseband amplifiers (BBAs). A common challenge encountered in these systems is the saturation of ADCs when signal levels exceed their dynamic range, leading to distorted outputs and loss of signal integrity.

A known approach for addressing ADC saturation involves automatic gain control (AGC) systems. These systems dynamically adjust the amplifier's gain to maintain signal levels within the ADC's acceptable range. In order to assure that the amplitude of the signal at the input of the decoding stages of the receiver system remains steady, the ADCs stream needs to be compensated when the gain is adjusted.

Given these existing solutions, a significant problem remains in managing the gain of analog amplifiers in receiver systems to avoid ADC saturation, while maintaining a steady output amplitude of the compensated ADCs signal which reaches the decoding stage of the receiver system. A solution of this problem is important for ensuring efficient and reliable signal processing in dynamic operating conditions.

### SUMMARY

It is thus an object to provide an improved method of operating a receiver system.

According to a first aspect there is provided a method of operating an NFC receiver system, the NFC receiver system comprising one or more channels, comprising:
supplying output signals from an analog amplifier unit to an ADC unit;
providing digital signals by the ADC unit and checking the digital signals, wherein in a case that the digital signals result from a level above a specified threshold of gain reduction of the analog amplifier unit, a gain of the analog amplifier unit is reduced; checking if the ADC unit is saturated, wherein in a case that the ADC unit is saturated, the gain of the analog amplifier unit is reduced and a specified gain reference is updated;
wherein in a case that the ADC unit is not saturated, the gain of the analog amplifier unit is reduced and the specified gain reference is left unamended; and generating a compensation signal from the gain of the analog amplifier unit and the specified gain reference, wherein the compensation signal is used to process the ADC signals in order to provide compensated digital signals having essentially steady amplitudes.

The proposed method improves keeping the decoded signal level steady when the amplifier gain is adjusted. An update of the reference gain level is performed according to the gain change of the analog amplifier of the received signal and the recent ADCs saturation status. This provides a technical advantage by ensuring that the decoded signal remains steady when the amplifier gain is adjusted, thus maintaining signal integrity. This may help to achieve a more or less steady output in all circumstances. Resulting therefrom, the signal to be decoded is kept constant. This may be useful, when the received signal is strong and the ADC unit is saturated despite adaptation of gain (as in conventional use cases). Advantageously, a digital signal is fed to the decoder which does not change in amplitude which may improve signal processing. In this way, the problem is addressed to compensate the ADCs stream when a gain of the amplifier unit changed (in general reduced).

According to a second aspect, a device for operating an NFC receiver system is provided, the device comprising:
one or more processors configured to:
supply output signals from an analog amplifier unit to an ADC unit;
provide digital signals by the ADC unit and checking the digital signals , wherein in a case that the digital signals result from a level above a specified threshold of gain reduction of the analog amplifier unit, a gain of the analog amplifier unit is reduced
check if the ADC unit is saturated, wherein in a case that the ADC unit is saturated, the gain of the analog amplifier unit is reduced and a specified gain reference of the analog amplifier unit is updated;
wherein in a case that the ADC unit is not saturated, the gain of the analog amplifier unit is reduced and the specified gain reference is left unamended; and
generate a compensation signal from the gain of the analog amplifier unit and the specified gain reference, wherein the compensation signal is used to process the ADC signals in order to provide compensated digital signals having essentially steady amplitudes.

In this way, the received signal from the NFC receiver system is configured to fit into the dynamic range of the ADC unit, which enables improved processing of the ADC signal.

According to one or more preferred embodiments, the reduction of the specified gain reference of the analog amplifier unit is performed depending on a degree of saturation of the ADC unit. This enables full or partial compensation in dependence of the clipping state of the ADC unit and allows for a granular adjustment of the reference level, optimizing a compensation process of baseband gain changes.

According to one or more preferred embodiments, the reduction of the specified reference value of the analog amplifier unit is carried out in specified steps. In this way, different degrees of saturation of the ADC unit can be taken into account.

According to one or more preferred embodiments, the reduction of the specified reference value of the analog amplifier unit is performed according to specified coarse or small steps. This provides flexibility in adjusting the reference gain, enabling fine-grained control over the compensation process and enhancing robustness in various scenarios. This offers the technical advantage of flexibility in gain adjustment, enabling improved compensation based on the clipping status and ensuring adaptability to varying signal conditions. According to one or more embodiments, the specified coarse steps are 6dB steps and wherein the specified small steps are 3dB steps. This offers a balance between coarse and fine adjustments of the reference gain, optimizing the compensation performance.

According to one or more preferred embodiments, for the sake of determining an reduction level of the gain of the specified reference value of the analog amplifier unit a time of saturation of the ADC unit is determined. In this way, the history of ADC saturation is taken into account, improving an accuracy of the gain adjustment. A simple way to implement such a recording option is, for example, a positive down counter.

According to one or more preferred embodiments, a status of the ADC unit is considered non-saturated, if a counter has reached zero after having counted down from a specific starting value. This provides an explicit criterion for determining the ADC saturation status, simplifying the control logic. In this way it can be determined that the ADC output has not clipped for an observed time.

According to one or more preferred embodiments, the check, whether the ADC unit is saturated is done by means of a digital circuitry or an analog overload detection unit. In this way, alternative ways to detect the saturation of the ADC unit may be implemented.

According to one or more preferred embodiments, the device comprises a compensation unit, the compensation unit comprising a clipping detector being functionally coupled to a counter unit, wherein the counter unit is configured to be reset to its initial value while an output signal of the ADC unit is clipping, wherein the counter unit is configured to start to count down as soon as the output signal of the ADC unit is not clipping and the reset is released. This makes it easy to determine that the ADC output has not overloaded for an observed time, allowing the compensation unit to take appropriate action in response.

According to one or more preferred embodiments, the compensation unit is functionally coupled with a correction logic configured to correct ADC unit output signals according to the determined reference level. In this way, the clipping detector together with the counter unit are able to determine a time of saturation of the ADC unit. This enables efficient tracking of the ADC saturation status, which is beneficial for an accurate gain compensation process.

According to one or more preferred embodiments, the correction logic comprises a positive correction logic to implement positive gain compensation and a negative correction logic to implement negative gain compensation. This allows for bidirectional gain compensation, accommodating both increases and decreases in the received signal strength. This can be done, e.g., with a correction factor > 1 or < 1.

According to one or more preferred embodiments, the compensation unit comprises a storage unit configured to store data regarding a predefined time amount of saturation of the ADC unit. This makes it possible to easily define a saturation state of the ADC unit over a period of time.

A system of one or more computers can be configured to perform particular operations or actions by virtue of having software, firmware, hardware, or a combination of them installed on the system that in operation causes or cause the system to perform the actions. One or more computer programs can be configured to perform particular operations or actions by virtue of including instructions that, when executed by data processing apparatus, cause the apparatus to perform the actions.

The above discussion/summary is not intended to describe each implementation of the present disclosure. The drawings and detailed description that follow also exemplify various embodiments. The aspects defined above and further aspects of the present disclosure are apparent from the examples to be described hereinafter with reference to the appended drawings, which are explained with reference to the examples. The disclosure is not limited to the described examples.

All illustrations in the drawings are schematical. It is noted that in different figures, similar or identical elements or features are provided with the same reference signs or with reference signs that are different from the corresponding reference signs only within the first digit. In order to avoid unnecessary repetitions, elements or features which have already been elucidated with respect to a previously described implementation are not elucidated again at a later position of the description.

### BRIEF DESCRIPTION OF THE DRAWINGS

The present disclosure can be better understood regarding the following drawings and descriptions. The components in the drawings are not necessarily to scale, emphasis being placed upon illustrating various preferred embodiments.
FIG. 1 shows a block diagram of an NFC receiver system;
FIGs. 2 to 5 show various operational scenarios of an NFC receiver system;
FIG. 6 shows in more detail elements of the NFC receiver system used to perform the proposed method;
FIG. 7 shows signal plots using a conventional mechanism of compensation of gain change;
FIG. 8 shows signal plots using the proposed mechanism of compensation of gain change;
FIG. 9 shows simulation plots comparing the conventional mechanism and the proposed mechanism of compensation of gain change; and
FIG. 10 shows a flow diagram of the proposed method.

### DESCRIPTION OF EMBODIMENTS

While various embodiments discussed herein are amenable to modifications and alternative forms, aspects thereof have been shown by example in the drawings and will be described in detail. It should be understood, that the intention is not to limit the disclosure to the particular embodiments described. The purpose is to cover all modifications, equivalents, and alternatives falling within the scope of the disclosure including aspects defined in the claims. In addition, the term "example" as used throughout this application is only by way of illustration, and not limitation.

An improved gain compensation mechanism for an NFC receiver system is proposed, maintaining relatively steady output levels at the end of a matched filter chain of the NFC receiver system. It uses a clipping detector, which is able to detect a saturation mode of an analog-to-digital converter (ADC) unit and to obtain a duration of the recent ADC saturation status. A knowledge of recent ADC saturation status is exploited to adjust a reference gain level for a non-saturated ADC unit. The proposed method applies positive or negative gain compensation (positive gain compensation: factor > 1, negative gain compensation: factor < 1) based on a reference gain level and the actual gain level of the analog amplifier unit 103.

Hereinafter, when "clipping" is referred to, this refers to an saturation state of an ADC unit. In other words, the terms "clipping" and "saturation" are synonyms and mean the same thing in the context of the present disclosure.

Hereinafter, when "raw data" is referred to, this refers to unoperated output data of an ADC unit. By contrast, "compensated data" or "corrected data" refers to output data of the ADC unit that have been revised using the proposed method. The terms "compensated" and "corrected" are synonymous.

Hereinafter, when a ADC unit is referred to, this refers to at least one analog-to-digital converter of the ADC unit, each of those analog-to-digital converters providing digital data of an RF or baseband signal.

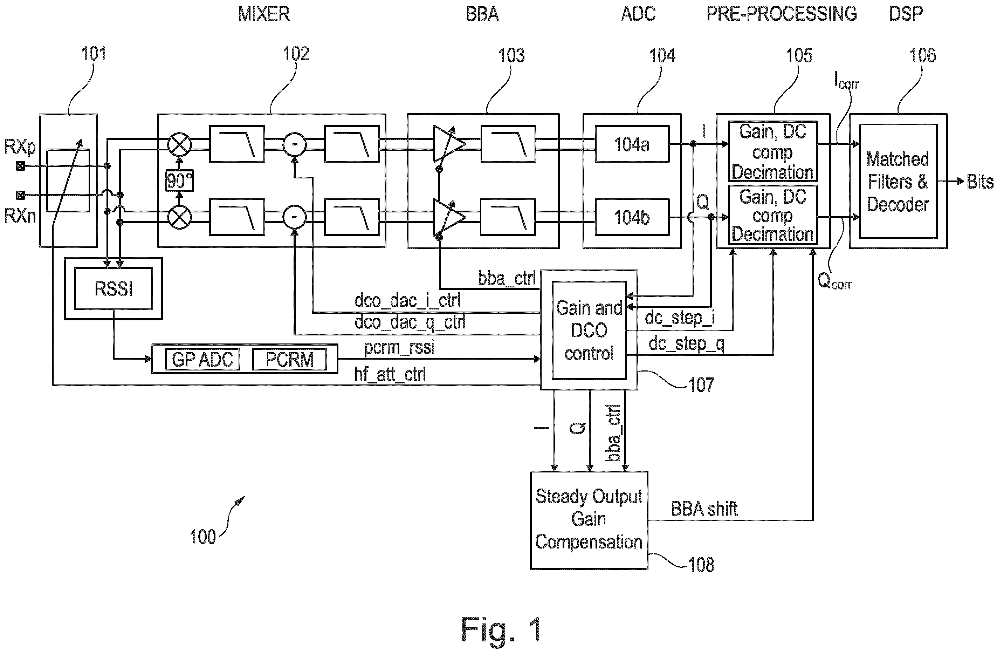

FIG. 1 illustrates a comprehensive block diagram of the NFC receiver system 100 which is integral to the NFC (Near Field communication) receiver's architecture. This representation includes a HF-attenuator 101, a mixer unit 102, an analog amplifier unit 103, an ADC unit 104, a pre-processing unit 105, a decoder unit 106, a control unit 107 and a compensation unit 108.

Regarding the circuitry shown in FIG. 1, only relevant signals for the present disclosure are illustrated in more detail. The NFC receiver system 100 is central to the NFC communication architecture, featuring several interconnected components. The HF-attenuator 101 receives incoming high-frequency signals and attenuates them as necessary before passing them to the mixer unit 102. The mixer unit 102 down-converts the frequency of the received signals, preparing them for amplification by the analog amplifier unit 103. The amplified signals are then digitized by the ADC unit 104, forming the digital signal input for the pre-processing unit 105. The decoder unit 106 (e.g. as part of a digital signal processor, DSP) comprises matched filters and is responsible for the primary signal processing tasks as decoding, guided by directives from the pre-processing unit 105. The compensation unit 108 and the pre-processing unit 105 adjust signal levels to maintain steady input signals to the decoder unit 106.

The compensation unit 108 itself takes the raw ADC signals I, Q and the current BBA gain (BBA_ctrl) as inputs and provides a BBA correction index (gain_shift, BBA_ref) representing a compensation factor for the pre-processing unit 105 in order to provide corrected ADC data.

Adapting the baseband gain factor in an analog front-end of an NFC (near field communication) receiver is necessary to fit the typically large dynamic range of the load modulation amplitude (LMA) to the limited dynamic range of the ADCs of an ADC unit 104. Considering the exemplary block diagram of an NFC receiver system 100 shown in FIG. 1, the analog amplifier unit 103 (analog baseband amplifier unit, BBA) amplifies the LMA after the down-conversion of received signals to the baseband by the mixer unit 102. Output baseband signals of the mixer unit 102 are fed to the analog amplifier unit 103. With the NFC receiver system 100 being implemented as a NFC receiver operating as a PCD (proximity coupling device), the BBA gain needs to be dynamically tracked during the PICC (proximity inductive coupling card) response to make sure that the dynamic range of the ADC unit 104 is sufficiently exploited, i.e., the signal must be high enough to allow for robust reception, but should not be saturated at the boundaries of the ADC range.

As also shown in FIG. 1, the NFC receiver system 100 comprises a compensation unit 108 (steady output gain compensation module), which is used to make the pre-processing unit 105 able to provide corrected ADC sigals Icorr, Qcorr which are fed to the decoder unit 106. The compensation unit 108 provides a steady output gain compensation and is operably situated between the control unit 107 (digital regulation module) performing gain and DC-offset control for the analog receiver front-end and a pre-processing unit 105 (digital gain compensation module) being arranged downstream of the ADC unit 104. The pre-processing unit 105 comprises two compensation elements, one for each of the I data, Q data (ADC raw data). Corrected (compensated) ADC data Icorr, Qcorr of the I channel, Q channel, respectively, are available at the output of the pre-processing unit 105 and are fed to the decoder unit 106.

The raw digital data I, Q are in a feedback loop via a control unit 107 back to the analog amplifier unit 103 which is controlled by a signal BBA_ctrl provided by the control unit 107 to the analog amplifier unit 103 and to the compensation unit 108. Further feedback signals dco_dac_i_ctrl, dco_dac_q_ctrl are fed to the mixer unit 102. The control unit 107 regulates the gain of the analog amplifier unit 103 according to signal level requirements such as no saturation but sufficient signal strength to avoid high quantization effects or total loss of signal. The control unit 107 processes the ADC output stream and aims to compensate the gain changes of the analog amplifier unit 103 by digitally applying an inverse of the gain change in the analog front-end to avoid the disturbances described above.

By means of the signal BBA_ctrl the concept of "BBA regulation" (i.e. usually BBA reduction) is handled. This means that the BBA value (amplification of the baseband input signal by means of the analog amplifier unit 103) is dynamically adjusted in order to fit the ADC dynamic range best. In contrast, the signal gain_shift handles the "BBA compensation" concept. This means a compensation of the the raw ADC data I, Q after having performed a BBA gain change, wherein the raw ADCs I, Q are corrected with the inverse of the BBA change. The BBA compensation / BBA correction steps have no direct impact on the analog amplifier unit 103 and are only used to process data as a result of a specific gain change at the analog amplifier unit 103.

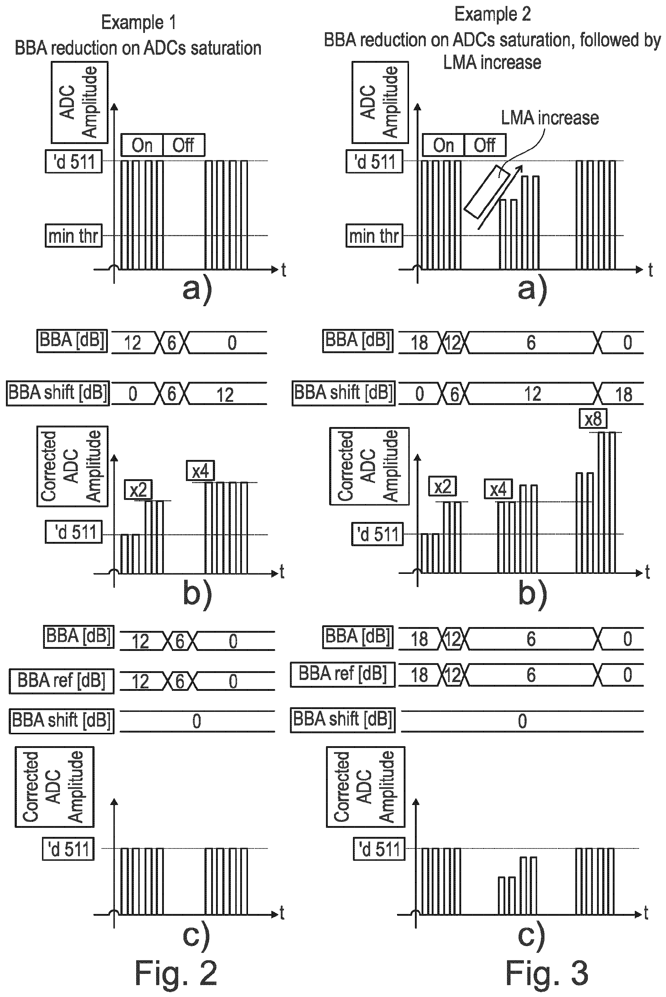

Two mechanisms are provided for the proposed method for steady output gain compensation:
1. During initial regulation during a preamble, a SOF (start-of-frame) or shortly after, a convergence to a reference signal gain takes place, where the signal of the ADC unit 104 is not clipped. This is represented by a BBA reference (BBA ref). As long as the LMA is clipping at the ADC output and the gain is being reduced, the value of BBA reference BBA ref is also reduced to keep track. If the signal at the ADC output is not clipping anymore, the BBA reference BBA ref has converged to the correct reference value and typically remains constant.
1. Determine a gain compensation factor BBA shift by calculating an offset between the current gain value and the reference gain value. This gain compensation factor is referred to as gain_shift as output signal of the compensation unit 108 shown in FIG. 1 and referenced as BBA shift in the timing diagrams of FIGs. 2 to 5. In case the current gain is below the reference gain, the BBA correction index is positive, whereas in case the current gain is above the reference gain, the BBA correction index is negative.

Since a granularity of the BBA correction index BBA shift is limited by design constraints (e.g., area, complexity, etc.), the consequences of the discrete gain adjustments need to be considered. For example, gain steps equal to or larger than 3dB might disturb the digital signal processing chain of the NFC receiver system 100, in particular the matched filters, the bit decoding, and the start-of-frame (SOF) and end-of-frame (EOF) detection mechanisms. Such disturbances can lead to failure in the PICC frame reception.

To reduce such disturbance and the risk of failing reception, digital compensation of the analog BBA gain changes have been proposed in US 10 735 038 B2 and US 11 043 929 B2. Considering a strong LMA, the signal might still be saturated at the ADC unit 104 after a gain reduction as illustrated below in more detail in the context of FIG. 2 (Example 1). In this case, the digital compensation of the ADC output will lead to an increased amplitude according to the compensation factor. This can disturb the digital processing chain in the same way as in an unsaturated scenario without gain compensation, with the only difference being that the direction of signal amplitude change will be the opposite (i.e., compensated digital signal increases after gain reduction).

In particular, a challenge with NFC receivers is performing the gain adaption and its digital compensation in real-time during reception without significant delays. Three representative example scenarios shall be considered in this context:
A first and a more straightforward case is shown in FIG. 2 (Example 1) and is characterized by a strong but constant LMA of a signal as shown in FIG. 2a. As can be seen, the BBA gain is adapted during the start-of-frame (SOF) at t = 0. With the strong and constant LMA, the output signal of the ADC unit 104 continues to be clipping at a level 511 (corresponding to a dynamic range -512, + 511 of a signed ADC with 10 bits), even after one or several gain reductions performed to the analog amplifier unit 103. This means that the ADC output amplitude does not change despite the performed gain change with the analog amplifier unit 103, and therefore, applying the gain compensation leads to an disturbance mentioned above where the amplitude of the compensated signal is actually increased by the gain compensation factor (BBA shift) as shown in FIG. 2b. As can be seen in FIG. 2b, output signals of the ADC unit 104 are "overcompensated" x2 as a consequence of adapting the gain of the analog amplifier unit 103 by 6dB and is overcompensated x4 as a consequence of adapting the gain of the analog amplifier unit 103 by 12dB.

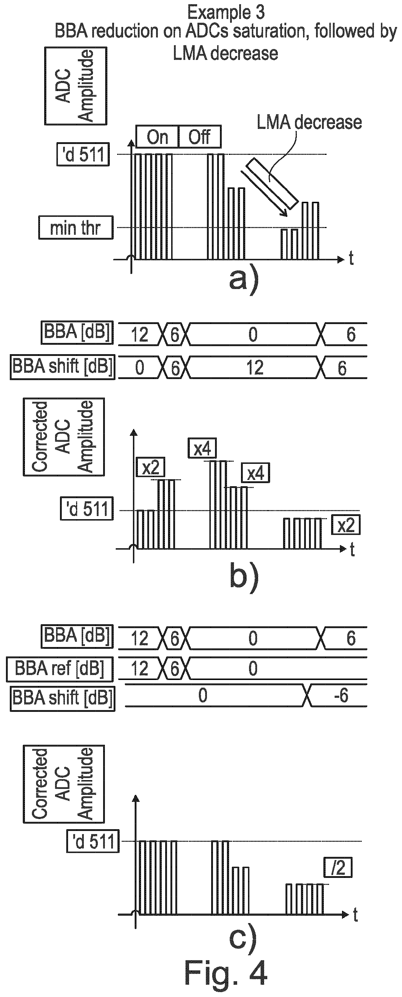

Second and third exemplary cases are shown in FIGs. 3b and 4b (Examples 2 and 3) and are characterized by a strong LMA at SOF, which continuously decreases or increases throughout the frame, e.g. due to an increasing or decreasing distance between PCD and PICC antenna. In this case, the gain of the analog amplifier unit 103 is typically adapted during the SOF with the aforementioned disturbances from example 1 in that same FIG. 2. In example 2 shown in FIG. 3a, the LMA increases, causing one or several additional gain reductions (from 18 dB to 12 dB, from 12dB to 6dB, and from 6dB to 0dB) once again, leading to the disturbances mentioned above. As can be seen in FIG. 3b, the signal is overcompensated x2 due to the correction of the analog amplifier unit 103 by 6dB, the signal is overcompensated x4 due to the correction of the analog amplifier unit 103 gain by 12dB and the signal is overcompensated x8 due to the correction of the analog amplifier unit gain by 18dB.

In an example 3 shown in FIG. 4a, the LMA of the signal decreases, causing one or several gain increases which do not lead to additional disturbances given that the ADC output stays in the linear range. As shown in FIG. 4a, the LMA decreases in combination with one or several additional gain adaptions (from 12 dB to 6 dB, from 6 dB to 0 dB, from 0 dB to 6 dB) once again leading to the disturbances mentioned above. FIG.4b illustrates that the signal is overcompensated x2 due to the correction of the gain of the analog amplifier unit 103 by 6dB, the signal is overcompensated x4 due to the correction of the gain of the analog amplifier unit 103 by 12dB.

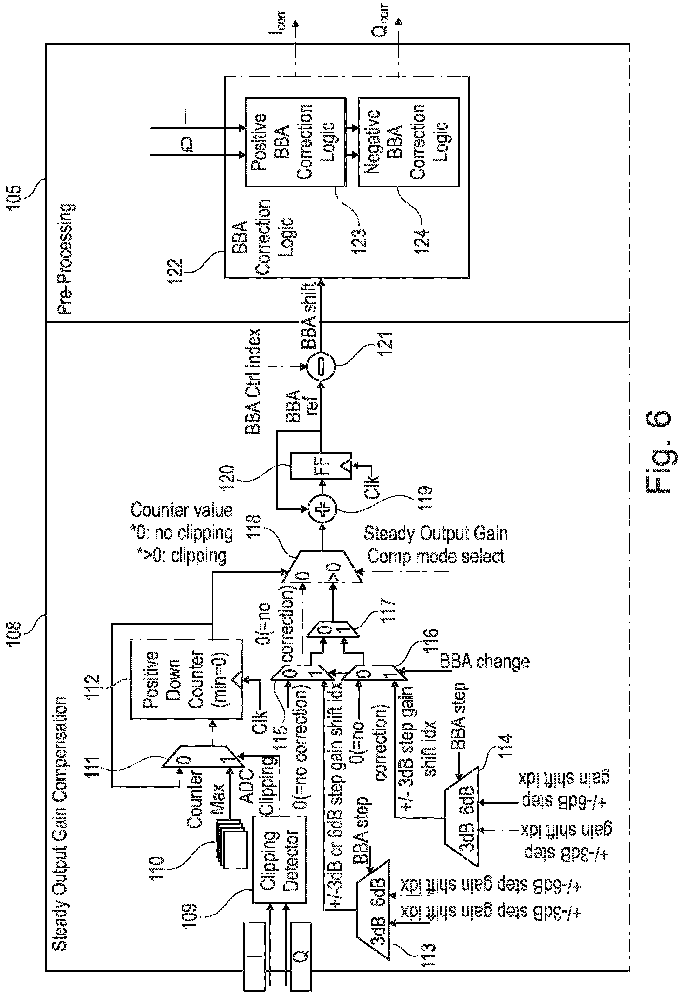

The proposed mechanism involves two pre-requisite steps: determining the clipping status (saturation state) of the ADC unit 104 after having performed a gain reduction for the analog amplifier unit 103 and updating the reference gain value on a BBA gain change event. The clipping status of the ADC unit 104 may be determined by a clipping detector 109, shown in the block diagram of FIG. 6, based on the ADC input signals. The basic clipping detection can be realized by checking if one of the signal levels hits either the positive or negative maximum value of the ADC unit 104. Assuming that the unmodulated DC level is centered around the zero range of a signed ADC unit, a strong LMA will not constantly saturate the ADC unit 104 but only during modulated periods. Therefore, the ADC clipping status may incorporate its recent history. An exemplary efficient way to implement this in hardware is a counter unit 112 implemented as a positive down-counter, which is reset to its initial value while the ADC output is clipping and starts to count down as soon as the ADC unit 104 is not clipping and the reset is released.

In the proposed gain compensation mechanism, the ADC status is considered non-clipping if the counter unit 112 has reached zero, i.e., the ADC output has not clipped for an observed amount of time. The observed amount of time can be adjusted and stored, e.g., in a storage unit 110 implemented as a look-up table (LUT), to fit the used data rate, the subcarrier frequency, and the current receiver status (e.g., initial regulation during SOF or tracking during PICC response).

FIG. 6 shows a high-level representation of a circuitry of the compensation unit 108 together with the pre-processing unit 105. The signal BBA ref moves in the same direction as the gain of the analog amplifier unit 103. If the gain of the analog amplifier unit 103 is changed the ADC unit 104 is not in saturation, the signal BBA ref having a specific starting value is kept on this specific value and does not change. If the gain of the analog amplifier unit 103 is changed and the ADC unit 104 is in saturation, the signal BBA ref is updated and the gain of the analog amplifier unit 103 is reduced. This works both when the gain of the analog amplifier unit 103 is reduced and when the gain of the analog amplifier unit 103 is increased. If there is clipping at the ADC unit 104, having been detected by the clipping detector 109, the counter unit 112 is started, wherein the counter unit 112 carries the knowledge of the status of the ADC unit 104. If the counter unit 112 is equal tot zero, the ADC unit 104 is not in saturation, thus, the signal BBA ref is not updated.

If the counter unit 112 is different to zero, then the signals BBA ref is updated. This also works if the gain of the analog amplifier unit 103 is increased, in this case the signal BBA ref will be kept constant and a negative correction logic 124 of a BBA correction logic 122 is used.

As shown in FIG. 6, on an analog-amplifier gain change event (change of BBA Ctrl Index), the BBA reference gain BBA ref is updated, if the ADC clipping status indicates the ADC unit 104 is clipping. If the ADC clipping status indicates the ADC unit 104 is not clipping, the BBA reference gain BBA ref is not updated. The BBA reference gain update usually equals the BBA gain change, with one exception in case of coarse gain steps available due to design constraints, e.g., BBA gain steps of 6dB. In this case, quite severe disturbance might be observed if the ADC unit 104 is only slightly saturated before a gain change, but the gain compensation applies the full compensation factor. Therefore, it may be beneficial to shift the reference gain according by a smaller step, e.g. by 3dB. This may be chosen with the signal Steady output Gain Comp mode select which is fed to a multiplexer 117. This may help to provide a good compromise for low disturbance in both severe and light saturation scenarios.

FIG. 6 shows that the compensation unit 108 uses multiple elements to achieve essentially constant signal levels of signals I_{corr}, Q_{corr} at outputs of the pre-processing unit 105. A clipping detector 109 continuously monitors the raw data signals I, Q of the ADC unit 104 for clipping events (saturation events of the ADC unit 104). A storage unit 110 contains a value of allowed clipping state of the ADC unit 104 which is then fed as a counter value to a multiplexer 111. An output of the multiplexer 111 is fed to a counter unit 112. In this way, the counter unit 112 is aware of an allowed duration of clipping of the ADC unit 104, which is used to determine the necessary gain compensation. A digital circuit section with three multiplexers 113, 114 and 116 is foreseen to specify a granularity of the gain shift. A summing point 119 is fed an output signal of a multiplexer 118, which aggregates the signals regarding allowed duration of clipping and granularity of gain change. A flip-flop 120 ensures stable signal transitions of the BBA reference.

Depending on the determined clipping status of the ADC unit 104, a positive correction logic 123 or a negative correction logic 124 is employed to correct the gain of the analog amplifier unit 103, without impacting the analog amplifier unit 103 and supporting steady levels of output signals I_{corr}, Q_{corr} which represent correct ADC values. The BBA correction logic 122 comprises a positive correction logic 123 and a negative correction logic 124, facilitating precise adjustments based on whether the raw signals I, Q of the ADC unit 104 need to be increased or decreased.

The circuitry of FIG. 6 represents a digital circuitry to detect whether the ADC unit 104 is saturated, i.e., whether a clipping of ADCs has taken place or not. Alternatively (not shown in figures), checking whether the ADC unit 104 is saturated can also be done by means of an analog overload detection unit.

The three example scenarios introduced above demonstrate the benefit of the proposed gain compensation mechanism.

Figures 2, 3, and 4 provide schematic representations of three key operational scenarios to be considered for the gain compensation mechanism in the NFC receivers. These include high static load modulation amplitude (LMA) (Example 1) and high dynamic LMA increasing and decreasing throughout a frame to be received (Examples 2 and 3).

Figures 2, 3 and 4 illustrate three operational scenarios for NFC receivers. Example 1 shows a static high LMA where the ADC unit 104 experiences constant clipping, necessitating gain reduction for the analog amplifier unit 103. Example 2 depicts an increasing LMA scenario, leading to further gain reductions throughout the frame.

Example 3 illustrates a decreasing LMA, where gain increases are applied without causing additional disturbances, thanks to the steady output gain compensation mechanism. These scenarios emphasize the need for robust gain control to ensure reliable NFC communication.

In FIG. 2 (Example 1), the gain of the analog amplifier unit 103 (shown via signal BBA) is reduced two times during SOF due to strong LMA. With a conventional gain compensation mechanism, as shown in FIG. 2b, the compensated ADC amplitude rises to four times the initial value. With the proposed mechanism as shown in FIG. 2c, the reference gain BBA ref follows the gain changes due to the clipping of the ADC unit 104. This results in no compensation being applied and the corrected ADC output signal I_{corr}, Q_{corr} has a steady amplitude at a level 511.

As discussed above, example 2 in FIG. 3 is similar to example 1 in FIG. 2 in terms of LMA during SOF, but the LMA continuously increases during the frame. Therefore, the gain of the analog amplifier unit 103 is reduced another time, later in the frame. While this might lead to additional disturbances with the conventional gain compensation, the proposed steady output mechanism also handles this scenario with minimized disturbance. The slight increase in the corrected ADC amplitude is related to the increasing LMA at the input and cannot be attributed to the gain compensation mechanism.

In FIG. 4 (example 3), the LMA is continuously decreasing during the frame. Increasing the gain of the analog amplifier unit 103 during the frame is typically handled correctly by the conventional gain compensation mechanism, given that the ADC unit 104 is not saturated by this gain increase. Still, the limitations during initial gain regulations apply. In case of the proposed mechanism, the scenario is also handled correctly with the compensation moving into the negative range in dB domain. This means, that a gain compensation factor < 1 is applied, in this example it is a factor of 1/2. This example shows that it is important to consider both factors greater and smaller than 1 to achieve steady output gain compensation in all scenarios. Similar to before, the slight decrease in the corrected ADC amplitude is related to the decreasing LMA at the input and cannot be attributed to the gain compensation mechanism.

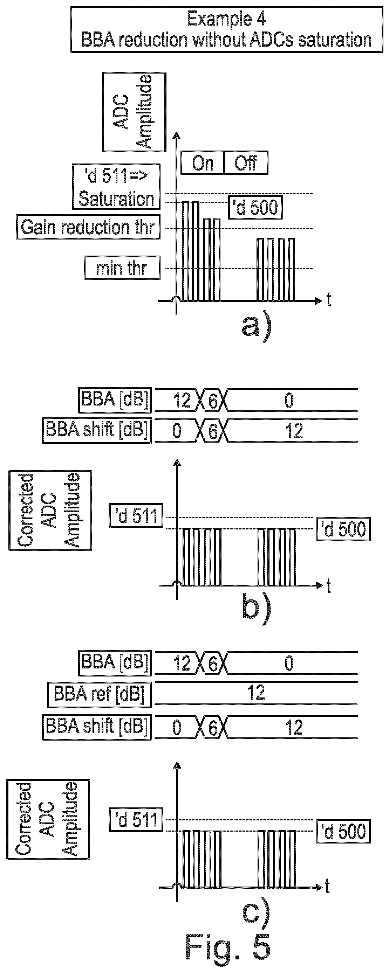

FIG. 5 shows a scenario where the ADC unit 104 is not clipping, and thus, the method of compensation of gain change does not get active. In other words, this represents a scenario where the conventional method and the proposed method behave in the same way. This is the case, in which the gain reduction of the analog amplifier unit 103 happens when the ADC unit 104 is in a linear operation mode (i.e. not in saturation mode over level 511). In particular, FIG. 5a shows an example of BBA gain reduction without ADC saturation in an NFC receiver system 100. As can be seen in FIG. 5a, the saturation mode starts at level 511. Output signals of the ADC unit 104 reach a level 500 and the gain reduction threshold (defined max. ADC-threshold to trigger a BBA gain reduction) is always below the level 511. FIG. 5b shows that the gain of the analog amplifier unit 103 is initially at 12 dB. The gain reduction threshold is initially below the signal level, and the minimum threshold min thr is also not reached over time t. In a first step, the gain of the analog amplifier unit 103 is reduced by 6 dB from 12dB to 6dB. In this case, the gain reduction threshold is again below the signal level, and the minimum threshold is not reached. In a second step, the gain of the analog amplifier unit 103 is reduced by 6 dB from 6 dB to 0 dB.

FIG. 5b shows an example of BBA gain reduction without ADC saturation in an NFC receiver system 100. As can be seen in FIG. 5b, the gain of the analog amplifier unit 103 is reduced twice in steps of 6dB (first reduction from 12dB to 6dB, second reduction from 6dB to 0dB), and the BBA gain (BBA shift) is correspondingly increased twice in steps of 6dB (first increase from 0dB to 6dB, second increase from 6dB to 12 dB). In FIG. 5c, the gain of the analog amplifier unit 103 is initially at 12 dB. The BBA reference gain is also 12 dB. The gain of the analog amplifier unit 103 is reduced to 6 dB, and since the gain reduction threshold is again below the signal level, it is further reduced to 0 dB. The BBA shift is now calculated based on the difference between the current BBA (0 dB) and the BBA reference (12 dB), resulting in a BBA shift of 12 dB. The corrected ADC amplitude is stable, demonstrating the effect of the steady output gain compensation.

FIG. 5c illustrates that since the ADC unit 104 is always in the linear region, also the reference level of BBA gain (BBA ref) remains constant at 12dB and is not adapted as performed in the ADC saturation scenarios of FIGs. 2 to 4.

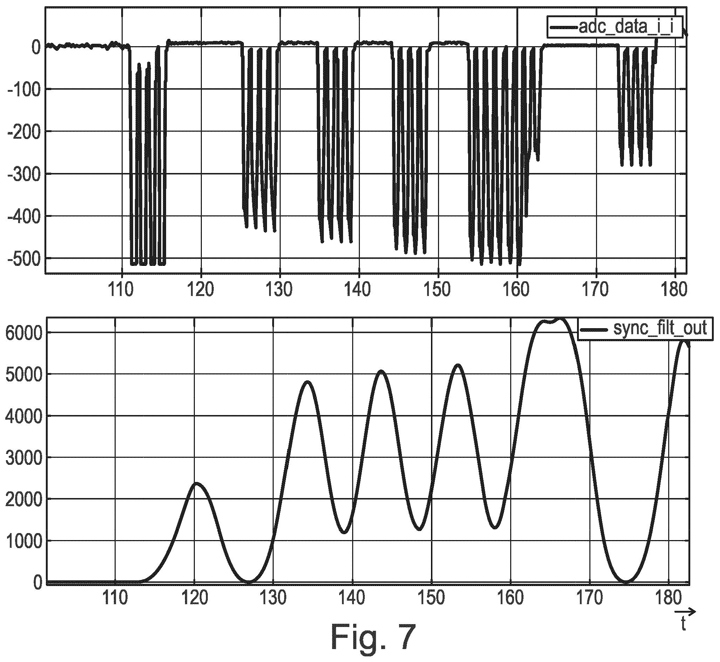

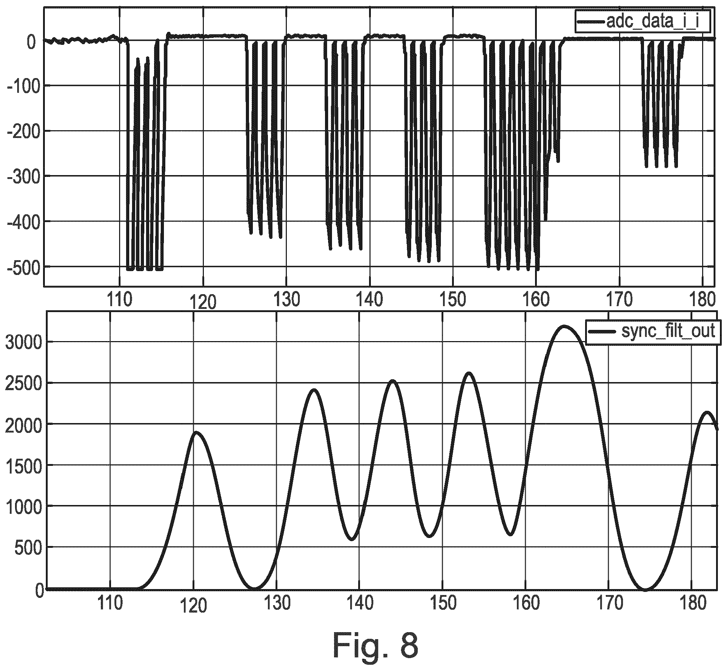

A similar scenario is shown in FIGs. 7 and 8 with signal captures from an exemplary implementation. The output of the ADC unit 104 is clipped at SOF until two gain changes have occurred. FIG. 7 shows signal plots using an exemplary hardware implementation of the conventional mechanism described in US 10 735 038 B2. The upper plot shows the ADC output, while the lower plot shows the output of the matched filter chain. The high variation of the peak levels indicate the disturbances in the compensated ADC data. As can be seen in FIG. 7, the matched filter output rises by more than 100% from the first peak (SOF) to the second peak (first data bit), whereas in FIG. 8, the matched filter output rises by only appr. 25% which means that the disturbing impact on decoding has been minimized.

FIG. 8 shows signal plots using an exemplary hardware implementation of the proposed mechanism. The upper plot shows the output of the ADC unit 104, while the lower plot shows the output of the matched filter chain. The relatively low variation of the peak levels indicate the absence of severe disturbances in the compensated ADC data.

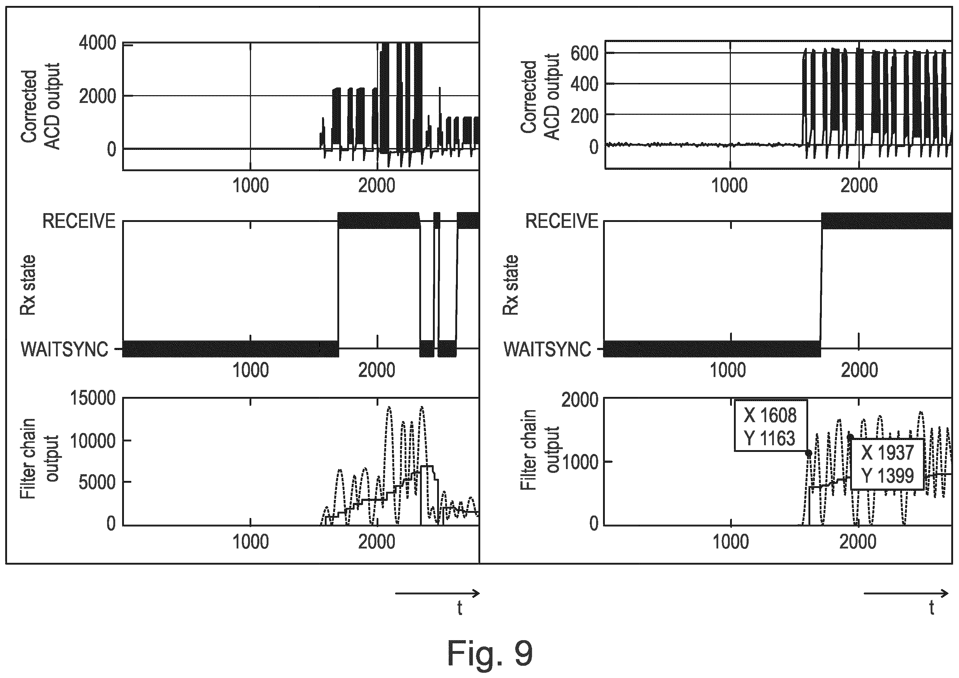

FIG. 9 demonstrates a similar example, but shows the corrected ADC data (top time curve) and the receiver state signal (middle time curve). In the left section of FIG. 9, the conventional mechanism is used and the disturbances of the corrected signal levels lead to a reception failure, indicated by the receiver state leaving the RECEIVE state, as shown in the middle time curve. In the right section of FIG. 9, the proposed method is used, leading to relatively steady corrected levels and no reception interruption.

FIG. 7 presents signal plots from an exemplary hardware implementation of the state-of-the-art gain compensation mechanism as described in prior art. The upper plot demonstrates the ADC output, while the lower plot depicts the output of the matched filter chain, highlighting disturbances in the compensated ADC data I_{corr}, Q_{corr}. The upper plot shows the ADC output, wherein a gain change has been performed to the analog amplifier unit 103 from the second group of subcarriers. The lower plot reveals the resultant output from the matched filter chain, where significant fluctuations in peak levels are observed, indicating the inadequacy of the existing mechanism in maintaining steady output. In more detail, it can be seen that a relation between first and second peak is very significant (from appr. 2.200 to appr. 4.800), which results in an overcompensation due to conventional BBA gain regulation, which can lead to fail mechanisms.

FIG. 8 presents signal plots from the proposed gain compensation mechanism. The upper plot demonstrates the gain change of the analog amplifier unit 103, which was identically performed in the upper plot of FIG. 7. The lower plot of the matched filter chain output shows minimal peak level changes (from appr. 1.900 to appr. 2.400), providing essentially consistent levels of ADC data I_{corr}, Q_{corr} and confirming an effectiveness of the proposed mechanism in minimizing disturbances and ensuring reliable signal processing by means of decoders of the decoder unit 106.

FIG. 9 offers a comparative view of simulation plots showing the conventional behavior (left) versus the proposed steady output mechanism (right). The plots demonstrate the impact of the mechanisms on signal reception, where the proposed mechanism ensures successful reception. FIG. 9 compares simulation plots of the conventional and proposed mechanisms. The left plot, representing the state-of-the-art, shows disruptions in signal reception (middle time curve), leading to failure in the communication between NFC devices. The right plot of the proposed mechanism illustrates stable corrected signal levels, ensuring successful reception and, thus, uninterrupted communication between NFC devices. This comparison underscores the enhanced performance and reliability of the proposed steady output gain compensation mechanism in various NFC communication scenarios.

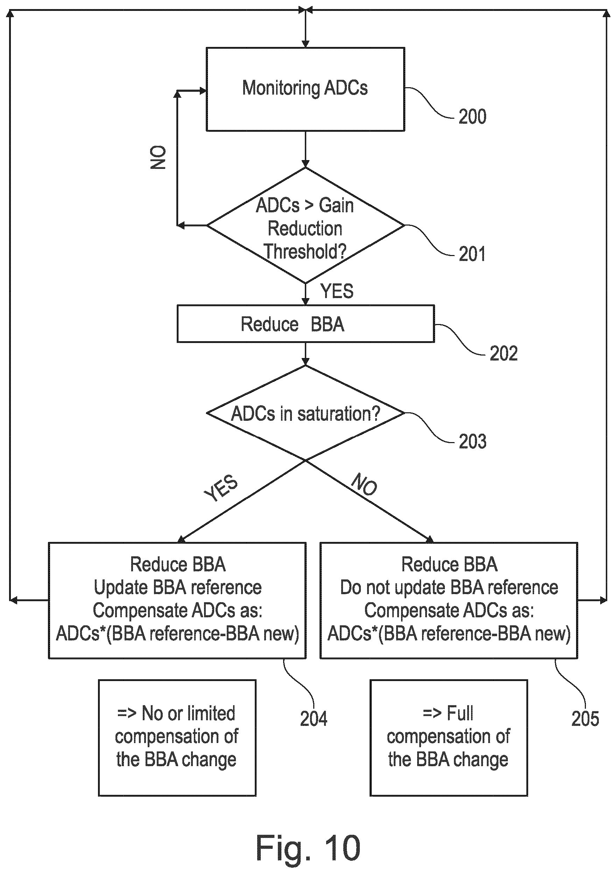

FIG. 10 is an exemplary representation of the proposed method for monitoring and compensating gain changes in ADCs (Analog-to-Digital Converters), highlighting the steps involved in adjusting the baseband amplifier (BBA) reference in response to different conditions. The figure illustrates a method for operating an NFC receiver system 100 with monitoring ADCs and adjusting the BBA reference to ensure accurate signal compensation.

The method starts with steps 200, 201, where the ADC unit 104 is monitored to determine if it exceeds a gain reduction threshold to be performed to the analog amplifier unit 103. In a step 202 the gain of the analog amplifier unit 103 is reduced. If this has taken place, the method jumps to step 203, where it is checked whether the ADC unit 104 is in saturation mode. If this is the case, the method proceeds to reduce the gain of the analog amplifier unit 103 (step 204) and corrects the BBA gain reference level BBA ref, resulting in a compensation of the output signal of the ADC unit 104 as ADCs * (BBA reference - BBA new). BBA new is the value of the gain after having been reduced in steps 202 and 204. This ensures no or limited compensation of the BBA change of the analog amplifier unit 103.

If it is determined the ADC unit 104 is not in saturation (step 205), the method refrains from updating the BBA gain reference BBA ref. Using the same formula as in step 204, the ADC unit 104 is compensated, resulting in a full compensation/correction of the performed BBA change to the analog amplifier unit.

Due to the fact, that in steps 204, 205 the reference values BBA ref are different, they have different effects. As a result of step 204, there is no or limited compensation of the BBA gain change, wherein as a result of step 205 there is a full compensation of the BBA gain change of the analog amplifier unit 103.

The disclosure provides a method for real-time hardware-based compensating of gain changes in an NFC receiver system 100. The steady output gain compensation mechanism maintains a steady output amplitude of the compensated/corrected signal, ensuring reliable decoding of received frames. It enables real-time operation in a HW implementation and supports various scenarios, including strong and dynamic LMA during frame reception. The disclosure provides a robust and efficient solution for gain compensation in NFC receivers and other communication systems, minimizing disturbances in the digital signal processing chain and improving reception reliability.

The proposed method can be applied to various communication systems beyond NFC, such as RFID, Bluetooth, and other wireless technologies, where gain adaptation and compensation are essential for reliable communication. The present disclosure may also improve the communication robustness in the other mentioned communication protocols. The proposed method enables that the ADCs function within their well-performing range, thereby preventing saturation and ensuring a steady output amplitude.

The system's adaptability in handling various LMA (load modulation amplitude) scenarios, such as strong or dynamic LMA, is a significant advantage. This adaptability is important for NFC receivers where real-time gain adaptation is necessary to maintain signal integrity. The described method ensures robust reception by dynamically adjusting the gain and compensating for any changes in the baseband amplifier, thereby preventing signal distortion and maintaining a steady output amplitude.

Overall, the concept described herein offers a comprehensive solution for real-time hardware-based digital compensation of baseband gain changes, particularly advantageous for applications requiring precise and dynamic signal management. In conclusion, the proposed method provides a robust solution for maintaining steady signal output in NFC receivers across different LMA scenarios. The innovative use of real-time gain compensation and clipping detection enables improved signal processing, enhancing the reliability and efficiency of NFC communication systems. Alternative embodiments may include adaptive gain control algorithms and integration with other communication protocols to expand the disclosure's applicability and performance.

The proposed gain compensation mechanism maintains steady output amplitude in all scenarios relevant for NFC receiver applications, including very strong LMA and dynamic LMA throughout a frame reception. It is suitable for efficient HW implementation and real-time operation without any processing delay.

The proposed method does not focus on the BBA regulation (on techniques to manage and adjust a gain of analog amplifiers), but on how to handle the compensation on the incoming ADC signal when the gain is changed (in general reduced).

Needless to say, that all mentioned numerical values are only exemplary and can be exchanged with alternative suitable numerical values. Also, the disclosed numerical values are to be understood in a qualitative sense and are represented in a standardized form. In the foregoing description various specific details have been set forth to describe specific examples presented herein. It should be apparent to one skilled in the art, that one or more other examples and/or variations of these examples may be practiced without all the specific details given below. In other instances, well known features have not been described in detail so as not to obscure the description of the examples herein. For ease of illustration, the same reference signs may be used in different diagrams to refer to the same elements or additional instances of the same element. Also, although aspects and features may in some cases be described in individual figures, it will be appreciated that features from one figure or disclosure can be combined with features of another figure or disclosure even though the combination is not explicitly shown or explicitly described as a combination.

As examples, the specification describes and/or illustrates aspects useful for implementing the claimed disclosure by way of various circuits or circuitry which may be illustrated as or using terms such as blocks, modules, device, system, unit, controller, etc. and/or other circuit-type depictions. Such circuits or circuitry are used together with other elements to exemplify how certain embodiments may be carried out in the form or structures, steps, functions, operations, activities, etc. As examples, wherein such circuits or circuitry may correspond to logic circuitry (which may refer to or include a code-programmed/configured CPU, in one example the logic circuitry may carry out a process or method (sometimes "algorithm") by performing such activities and/or steps associated with the above-discussed functionalities. In other examples, the logic circuitry may carry out a process or method by performing these same activities/operations.

For example, in certain of the above-discussed embodiments, one or more modules are discrete logic circuits or programmable logic circuits configured and arranged for implementing these operations/activities. In certain embodiments, such a programmable circuit is one or more computer circuits, including memory circuitry for storing and accessing a program to be executed as a set (or sets) of instructions (and/or to be used as configuration data to define how the programmable circuit is to perform), and an algorithm or process as described above is used by the programmable circuit to perform the related steps, functions, operations, activities, etc. Depending on the application, the instructions (and/or configuration data) can be configured for implementation in logic circuitry, with the instructions (whether characterized in the form of object code, firmware or software) stored in and accessible from a memory (circuit). As another example, where the specification may make reference to a "first" type of structure, a "second" type of structure, where the adjectives "first" and "second" are not used to connote any description of the structure or to provide any substantive meaning; such adjectives are merely used for English-language antecedence to differentiate one such similarly-named structure from another similarly-named structure.

Based upon the above discussion and illustrations, those skilled in the art will readily recognize, that various modifications and changes may be made to the various embodiments without strictly following the exemplary embodiments and applications illustrated and described herein. For example, methods as exemplified in the Figures may involve steps carried out in various orders, with one or more aspects of the embodiments herein retained, or may involve fewer or more steps.

It should be noted that the term "comprising" does not exclude other elements or steps and "a" or "an" does not exclude a plurality. Also, elements described in association with different embodiments may be combined.

The disclosed devices, units, elements, systems, and methods described herein may at least partially be embodied by a computer program or a plurality of computer programs, which may exist in a variety of forms, both active and inactive, in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals in compressed or uncompressed form.

It is noted that the embodiments above have been described with reference to different subject-matters. In particular, some embodiments may have been described with reference to method-type claims whereas other embodiments may have been described with reference to apparatus-type claims.

A person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

### Reference signs:

- 100: NFC receiver system
- 101: HF-attenuator
- 102: mixer unit
- 103: analog amplifier unit BBA
- 104: ADC unit
- 105: pre-processing unit
- 106: decoder unit
- 107: control unit
- 108: compensation unit
- 109: clipping detector
- 110: storage unit
- 111: multiplexer
- 112: counter unit
- 113-118: multiplexer
- 119: summing point
- 120: flip-flop
- 121: subtraction point
- 122: BBA correction logic
- 123: positive BBA correction logic
- 124: negative BBA correction logic
- 200-205: method steps
- 500, 511: levels of ADC
- BBA ref: reference value BBA gain
- BBA shift: shift of BBA gain
- I: digital signal (I data from ADC, raw data)
- Q: digital signal (Q data from ADC, raw data)
- I_{corr}: corrected I data
- Q_{corr}: corrected Q data

## Claims

1. A method of operating an NFC receiver system (100), the NFC receiver system (100) comprising one or more channels, the method comprising:
supplying output signals from an analog amplifier unit (103) to an ADC unit (104);
providing digital signals (I, Q) by the ADC unit (104) and checking the digital signals (I, Q), wherein in a case that the digital signals (I, Q) result from a level above a specified threshold of gain reduction of the analog amplifier unit (103), a gain of the analog amplifier unit (103) is reduced;
checking if the ADC unit (104) is saturated, wherein in a case that the ADC unit (104) is saturated, the gain of the analog amplifier unit (103) is reduced and a specified gain reference is updated;
wherein in a case that the ADC unit (104) is not saturated, the gain of the analog amplifier unit (103) is reduced and the specified gain reference (BBA ref) is left unamended; and
generating a compensation signal (BBA shift) from the gain of the analog amplifier unit (103) and the specified gain reference (BBA ref), wherein
the compensation signal (BBA shift) is used to process the ADC signals (I, Q) in order to provide compensated digital signals (I_{corr}, Q_{corr}) having essentially steady amplitudes.

2. The method according to claim 1, wherein the reduction of the specified gain reference (BBA ref) of the analog amplifier unit (103) is performed depending on a degree of saturation of the ADC unit (104).

3. The method according to claim 2, wherein the reduction of the specified reference (BBA ref) of the analog amplifier unit (103) is carried out in specified steps.

4. The method according to claim 3, wherein the reduction of the specified reference (BBA ref) of the analog amplifier unit (103) is performed according to specified coarse or small steps.

5. The method according to claim 4, wherein the specified coarse steps are 6dB steps and wherein the specified small steps are 3dB steps.

6. The method according to claim 5, wherein for the sake of determining an reduction level of the gain of the specified gain reference (BBA ref) of the analog amplifier unit (103) a time of saturation of the ADC unit (104) is determined.

7. The method according to claim 6, wherein a status of the ADC unit (104) is considered non-saturated, if a counter (112) has reached zero after having counted down from a specific starting value.

8. An NFC receiver system (100) configured to perform the method according to any of the preceding claims.

9. A device for operating an NFC receiver system (100) comprising:
one or more processors configured to:
supply output signals from an analog amplifier unit (103) to an ADC unit (104);
provide digital signals (I, Q) by the ADC unit (104) and checking the digital signals (I, Q), wherein in a case that the digital signals (I, Q) result from a level above a specified threshold of gain reduction of the analog amplifier unit (103), a gain of the analog amplifier unit (103) is reduced;
check if the ADC unit (104) is saturated, wherein in a case that the ADC unit (104) is saturated, the gain of the analog amplifier unit (103) is reduced and a specified gain reference (BBA ref) of the analog amplifier unit (103) is updated;
wherein in a case that the ADC unit (104) is not saturated, the gain of the analog amplifier unit (103) is reduced and the specified gain reference (BBA ref) is left unamended; and
generate a compensation signal (BBA shift) from the gain of the analog amplifier unit (103) and the specified gain reference (BBA ref), wherein the compensation signal (BBA shift) is used to process the ADC signals (I, Q) in order to provide compensated digital signals (Icorr, Qcorr) having essentially steady amplitudes.

10. The device according to claim 9, wherein the check, whether the ADC unit (104) is saturated is done by means of a digital circuitry or an analog overload detection unit.

11. The device according to claim 10, wherein the digital circuitry comprises a compensation unit (108), the compensation unit (108) comprising a clipping detector (109) being functionally coupled to a counter unit (112), wherein the counter unit (112) is configured to be reset to its initial value while an output signal of the ADC unit (104) is clipping, wherein the counter unit (112) is configured to start to count down as soon as the output signal of the ADC unit (104) is not clipping and the reset is released.

12. The device according to claim 11, wherein the compensation unit (108) is functionally coupled with a correction logic (122) configured to correct ADC unit output signals according to a determined reference level.

13. The device of claim 12, wherein the correction logic (122) comprises a positive correction logic (123) to implement positive gain compensation and a negative correction logic (124) to implement negative gain compensation.

14. The device of any of claims 11 to 13, the compensation unit (108) comprising a storage unit (110) configured to store data regarding a predefined time amount of saturation of the ADC unit (104).

## Amended claims

### Amended claims in accordance with Rule 137(2) EPC.

1. A method of operating an NFC receiver system (100), the NFC receiver system (100) comprising one or more channels, the method comprising:
supplying output signals from an analog amplifier unit (103) to an ADC unit (104);
providing digital signals (I, Q) by the ADC unit (104) and checking the digital signals (I, Q), wherein in a case that the digital signals (I, Q) result from a level above a specified threshold of gain reduction of the analog amplifier unit (103), a gain of the analog amplifier unit (103) is reduced;
checking if the ADC unit (104) is saturated, wherein in a case that the ADC unit (104) is saturated, the gain of the analog amplifier unit (103) is reduced and a specified reference gain (BBA ref) is updated; wherein the specified reference gain (BBA ref) is updated in response to detection of ADC saturation, to follow the gain reduction of the analog amplifier unit (103) according to the recent saturation status of the ADC unit (104);
wherein in a case that the ADC unit (104) is not saturated, the gain of the analog amplifier unit (103) is reduced and the specified reference gain (BBA ref) is left unamended; and
generating a compensation signal (BBA shift) from a current gain (bba_ctrl) of the analog amplifier unit (103) and the specified reference gain (BBA ref), wherein the compensation signal (BBA shift) is used to process the ADC signals (I, Q) in order to provide compensated digital signals (I_{corr}, Q_{corr}) having essentially steady amplitudes.

2. The method according to claim 1, wherein the reduction of the specified reference gain (BBA ref) of the analog amplifier unit (103) is carried out in specified steps.

3. The method according to claim 2, wherein the reduction of the specified reference gain (BBA ref) of the analog amplifier unit (103) is performed according to specified coarse or small steps.

4. The method according to claim 3, wherein the specified coarse steps are 6dB steps and wherein the specified small steps are 3dB steps.

5. The method according to claim 4, wherein for the sake of determining an reduction level of the specified reference gain (BBA ref) of the analog amplifier unit (103) a time of saturation of the ADC unit (104) is determined.

6. The method according to claim 5, wherein a status of the ADC unit (104) is considered non-saturated, if a counter (112) has reached zero after having counted down from a specific starting value.

7. An NFC receiver system (100) configured to perform the method according to any of the preceding claims.

8. A device for operating an NFC receiver system (100) comprising:
one or more processors configured to:
supply output signals from an analog amplifier unit (103) to an ADC unit (104);
provide digital signals (I, Q) by the ADC unit (104) and checking the digital signals (I, Q), wherein in a case that the digital signals (I, Q) result from a level above a specified threshold of gain reduction of the analog amplifier unit (103), a gain of the analog amplifier unit (103) is reduced;
check if the ADC unit (104) is saturated, wherein in a case that the ADC unit (104) is saturated, the gain of the analog amplifier unit (103) is reduced and a specified reference gain (BBA ref) of the analog amplifier unit (103) is updated, wherein the specified reference gain (BBA ref) is updated in response to detection of ADC saturation, to follow the gain reduction of the analog amplifier unit (103) according to the recent saturation status of the ADC unit (104);
wherein in a case that the ADC unit (104) is not saturated, the gain of the analog amplifier unit (103) is reduced and the specified reference gain (BBA ref) is left unamended; and
generate a compensation signal (BBA shift) from the gain of the analog amplifier unit (103) and the specified reference gain (BBA ref), wherein the compensation signal (BBA shift) is used to process the ADC signals (I, Q) in order to provide compensated digital signals (Icorr, Qcorr) having essentially steady amplitudes.

9. The device according to claim 8, wherein the check, whether the ADC unit (104) is saturated is done by means of a digital circuitry or an analog overload detection unit.

10. The device according to claim 9, wherein the digital circuitry comprises a compensation unit (108), the compensation unit (108) comprising a clipping detector (109) being functionally coupled to a counter unit (112), wherein the counter unit (112) is configured to be reset to its initial value while an output signal of the ADC unit (104) is clipping, wherein the counter unit (112) is configured to start to count down as soon as the output signal of the ADC unit (104) is not clipping and the reset is released.

11. The device according to claim 10, wherein the compensation unit (108) is functionally coupled with a correction logic (122) configured to correct ADC unit output signals according to a determined reference level.

12. The device of claim 11, wherein the correction logic (122) comprises a positive correction logic (123) to implement positive gain compensation and a negative correction logic (124) to implement negative gain compensation.

13. The device of any of claims 10 to 12, the compensation unit (108) comprising a storage unit (110) configured to store data regarding a predefined time amount of saturation of the ADC unit (104).
